# EUROPÄISCHE PATENTSCHRIFT

(11) **EP 1 385 057 B1**
(45) Veröffentlichungstag und Bekanntmachung des Hinweises auf die Patenterteilung: **11.05.2011**
(21) Anmeldenummer: 03014416.6
(22) Anmeldetag: 30.06.2003
(51) Int. Cl.: G03F 7/20, G02B 13/24, B41J 2/45, H04N 1/192

(54) **Kompakte Einrichtung zur Bebilderung einer Druckform**
Compact device for exposing a printing form
Appareil compact pour l'exposition d'un élément d'impression

(30) Priorität: 24.07.2002 DE 10233491
(43) Veröffentlichungstag der Anmeldung: 28.01.2004
(73) Patentinhaber: Heidelberger Druckmaschinen Aktiengesellschaft, 69115 Heidelberg (DE)
(72) Erfinder: Forrer, Martin, Dr., 9008 St. Gallen (CH); Gebhardt, Axel, 24248 Mönkeberg (DE); Langenbach, Eckhard, 9037 Speicherschwendi (CH); Paulsen, Lars, 25788 Hollingstedt (DE); Rupp, Thomas, 69126 Heidelberg (DE)

(56) Entgegenhaltungen:
- EP-A2- 0 601 485
- WO-A-91/17483
- US-A1- 2001 026 391
- US-B1- 6 172 788

## Beschreibung

Die Erfindung betrifft eine Einrichtung zur Bebilderung einer Druckform, mit einer Anzahl von Lichtquellen und einer Abbildungsoptik zur Erzeugung einer Anzahl von Bildpunkten der Lichtquellen auf der Druckform, wobei die Abbildungsoptik wenigstens eine Makrooptik aus refraktiven optischen Komponenten umfasst.

Zur Strukturierung von Druckformen, insbesondere Druckplatten, in farbannehmende und farbabstoßende Bereiche wird häufig die zunächst unstrukturiert in einem Zustand, beispielsweise farbannehmend, vorliegende Oberfläche der Druckform partiell der Einwirkung von elektromagnetischer Strahlung, insbesondere Wärme oder Licht verschiedener Wellenlängen, ausgesetzt, so dass der andere Zustand, beispielsweise farbabstoßend, an den Positionen der Einwirkung erzeugt wird. Um eine gezielte, präzise und schnelle Belichtung einer Druckform auszuführen, werden oft eine Anzahl von einzeln ansteuerbaren Lichtquellen, insbesondere Laserlichtquellen, die in einem Array in Reihen oder Matrixform angeordnet sind, im Parallelbetrieb eingesetzt, welche mittels einer Abbildungsoptik auf die Oberfläche der Druckform, welche im Bildfeld der Abbildungsoptik angeordnet ist, projiziert werden.

An eine Abbildungsoptik in einer gattungsgemäßen Einrichtung zur Bebilderung einer Druckform, sei es in einem Druckformbelichter oder einem Druckwerk, werden dabei eine Reihe von Anforderungen zur Erfüllung verschiedener Funktionalitäten gestellt. Zum einen hat ein Teil der Abbildungsoptik den Zweck einer globalen, möglichst abbildungsfehlerfreien Projektion der Anzahl von Lichtquellen auf Bildpunkte. Dieser Teil wird im Zusammenhang dieser Darstellung als Makrooptik bezeichnet. Zum anderen können weitere Teile der Abbildungsoptik oder Teile der Makrooptik selbst weitere Funktionalitäten, beispielsweise eine Möglichkeit zur Anpassung der Fokusposition, erfüllen.

Häufig bestehen die Lichtquellenarrays aus einer bestimmten Anzahl von einzeln ansteuerbaren Diodenlasem, bevorzugt Single-Mode-Diodenlasern, welche in bestimmtem Abstand zueinander, typischerweise im wesentlichen gleich beabstandet, auf einem Halbleitersubstrat angeordnet sind und welche über eine gemeinsame über die Kristallbruchebene genau definierte Austrittsebene verfügen (IAB, individually addressable bar, einzeln ansteuerbarer Diodenlaserbarren). Da die Lichtemissionskegel dieser Diodenlaser in den zwei zueinander im wesentlichen orthogonal stehenden Symmetrieebenen unterschiedlich weit geöffnet sind, ergibt sich die Notwendigkeit einer optischen Korrektur zur Verringerung der asymmetrischen Divergenz des austretenden Lichtes. Es kann eine individuelle Anpassung des Öffnungswinkelverhältnisses vorgenommen werden. Diese Korrektur wird auf die einzelnen Lichtquellen bezogen mit einem Teil der Abbildungsoptik ausgeführt, welcher auch als Mikrooptik bezeichnet wird.

Aus dem Stand der Technik ist eine Reihe von Abbildungsoptiken bekannt, welche speziell für die Abbildung von Diodenlaserreihen zur Bebilderung eines Bildträgers realisiert wurden. Beispielsweise ist aus dem Dokument US 4,428,647 eine Einrichtung zur Bebilderung mit einem Halbleiterlaserarray bekannt, dessen einzelnen Lasern jeweils eine in der Nähe befindliche Linse zur Divergenzkorrektur zugeordnet ist. Das Licht der Halbleiterlaser wird anschließend durch eine Objektivlinse gesammelt und auf einen Bildträger fokussiert. Aus dem Dokument EP 0 878 773 A2 ist eine Einrichtung zur Bebilderung mit einem individuell adressierbaren Diodenlaserarray bekannt. Die Abbildungsoptik weist einen mikrooptischen Teil und einen makrooptischen Teil auf. Der makrooptische Teil ist eine beidseitig telezentrische konfokale Linsenanordnung. Aus dem vorangemeldeten Dokument DE 101 15 875.0 geht eine Einrichtung zur Bebilderung mit einem Array von Lichtquellen hervor. Die Abbildungsoptik umfasst eine Mikrooptik, welche virtuelle Zwischenbilder der Lichtquellen erzeugt, und eine Makrooptik, welche einen Konvexspiegel und einen Konkavspiegel mit gemeinsamem Krümmungsmittelpunkt, eine Kombination vom sogenannten Offner-Typ, umfasst und welche ein reelles Bild der virtuellen Zwischenbilder erzeugt.

Die US 6,172,788 B1 offenbart eine Bebilderungseinrichtung für elektrofotografische Oberflächen mit zwei Laserdioden und einer Makroptik, wobei die Makroptik refraktive optische Elemente umfasst und beide Strahlengänge ausgehend von den beiden Laserdioden jeweils zweifach durch die Makroptik verlaufen. Die beiden Strahlengänge verlaufen dabei unsymmetrisch zur optischen Achse der Makroptik, wodurch recht viel Bauraum zur Anordnung der jeweiligen Komponeneten, insbesondere der beiden Laserdioden beansprucht wird.

Den aus dem Stand der Technik bekannten Lösungen ist gemein, dass sie im Vergleich zu ihren Funktionalitäten einen großen Bauraum erfordern. Eine Modifikation oder Ergänzung um weitere Funktionalitäten ist nur schwer erreichbar. Da zum einen der Bauraum in derartigen Maschinen sehr begrenzt ist, zum anderen auch am Aufbau oder an der Konfiguration des Druckformbelichters oder des Druckwerkes für die Implementierung einer Bebilderungseinrichtung wenig abgeändert werden kann, ist eine Reduzierung des benötigten Bauraumes der Abbildungsoptik erforderlich, ohne die notwendigen Funktionalitäten einzuschränken. Des weiteren ist eine Abbildungsoptik an einer Druckmaschine oder einem Druckformbelichter Erschütterungen oder Vibrationen ausgesetzt, so dass aus dem Stand der Technik bekannte optische Anordnungen in der Regel nicht einfach für die Verwendung an einem Druckformbelichter oder innerhalb eines Druckwerkes einer Druckmaschine übertragen werden können.

Aufgabe der vorliegenden Erfindung ist es, eine kompakte Einrichtung zur Bebilderung einer Druckform zu schaffen, welche eine einfache Integration in den zur Verfügung stehenden Bauraum in einem Druckwerk einer Druckmaschine gestattet.

Diese Aufgabe wird erfindungsgemäß durch eine Einrichtung zur Bebilderung einer Druckform mit den Merkmalen gemäß Anspruch 1 gelöst. Vorteilhafte Weiterbildungen der Erfindung sind in den abhängigen Ansprüchen charakterisiert.

Erfindungsgemäß weist eine Einrichtung zur Bebilderung einer Druckform eine Anzahl von Lichtquellen und eine Abbildungsoptik zur Erzeugung einer Anzahl von Bildpunkten der Lichtquellen auf der Druckform auf. Die Abbildungsoptik umfasst wenigstens eine Makrooptik aus refraktiven optischen Komponenten oder optischen Elementen, insbesondere eine Anzahl von Linsen, durch welche der Strahlengang von den Lichtquellen zu den Bildpunkten zweifach verläuft wobei der Strahlengang symmetrisch zur optischen Achse der Makrooptik verläuft, insbesondere kann der erste Weg zum zweiten Weg symmetrisch verlaufen. Im Zusammenhang dieser Darstellung seien unter dem Wort Strahlengang alle Strahlengänge der Anzahl von Lichtquellen verstanden. Insbesondere werden die refraktiven optischen Komponenten zweimal durchlaufen. Es sind die refraktiven optischen Komponenten, welche einen wesentlichen Beitrag zur Erzeugung der Anzahl von Bildpunkten leisten. Durch den mehrfachen oder erneuten Verlauf des Strahlengangs durch die Makrooptik kann bei gleichbleibender Funktionalität die Makrooptik kompakter und bauraumsparender im Vergleich zu einer Makrooptik mit einfachem Strahlengang ausgeführt werden. Die Anzahl der Lichtquellen kann auch 1 betragen, bevorzugt sind aber mehrere Lichtquellen vorgesehen. Die Lichtquellen können in einem eindimensionalen (Linie, bevorzugt) oder einem zweidimensionalen Array, insbesondere einem regelmäßigen, bevorzugt cartesisch, angeordnet sein. Lichtquellen und Bildpunkte stehen in einem eineindeutigen funktionellen Zusammenhang zueinander. Die Bildpunkte liegen disjunkt zueinander. Die Bildpunkte können dicht oder bevorzugt nicht dicht zueinander liegen, das heißt, ihr Abstand kann größer als der minimale Abstand der zu setzenden Druckpunkte sein. Der Abstand benachbarter Bildpunkte auf der Druckform zueinander in Einheiten des minimalen Druckpunktabstands ist bevorzugt eine natürliche Zahl, die teilerfremd zu der Anzahl der Bildpunkte (Lichtquellen) ist. Die Druckform ist bevorzugt eine Offsetdruckform.

Der Strahlengang kann dabei nicht-zentrisch durch die Makrooptik verlaufen. Insbesondere kann der Strahlengang auf dem ersten Weg durch die Makrooptik ein anderer sein als auf dem zweiten Weg durch die Makrooptik.

Der zweifache Verlauf des Strahlengangs durch die Makrooptik kann derart sein, dass die erste Hauptebene und die zweite Hauptebene der Makrooptik auf einer Seite der Makrooptik liegen. Die Makrooptik kann derart ausgeführt sein, dass Gegenstände (Anzahl von Lichtquellen) und Bilder auf einer Seite der Makrooptik liegen. Anders ausgedrückt, der Strahlengang passiert die Makrooptik auf dem ersten Weg in eine erste Richtung und auf dem zweiten Weg in die zur ersten Richtung entgegengesetzten Richtung.

In einer vorteilhaften Ausführungsform der Einrichtung zur Bebilderung einer Druckform ist der Makrooptik wenigstens ein Spiegel, insbesondere einen Planspiegel, zugeordnet. Die Makrooptik kann derart ausgeführt sein, dass der Strahlengang auf seinem ersten Weg die Makrooptik in einer ersten Richtung durchläuft, bis das Licht auf den wenigstens einen Spiegel trifft, um dann auf seinem zweiten Weg die Makrooptik in der zur ersten Richtung entgegengesetzten Richtung zu durchlaufen. Die Makrooptik entspricht quasi einer doppelt so großen optischen Anordnung. In anderen Worten ausgedrückt, eine aus einer Anzahl von optischen Elementen bestehende Makrooptik ist durch den oder die Spiegel optisch doppelt so groß oder verdoppelt, wobei der oder die Spiegel das Licht in einen symmetrischen zweiten Durchgang durch die Makrooptik reflektiert.

In einer erfindungsgemäßen Einrichtung zur Bebilderung einer Druckform kann die Makrooptik wenigstens einen als adaptive Optik ausgeführten Teil umfassen oder kann wenigstens einer der zugeordneten Spiegel adaptiv ausgeführt sein. Insbesondere kann wenigstens einer der zugeordneten Spiegel als adaptiver Spiegel, d. h. mit variablem Krümmungsradius oder mit variabler Oberflächenstruktur, ausgeführt sein. Durch Variation des Krümmungsradius kann die Bildweite verändert werden. Eine Variation des Krümmungsradius ist klein gegenüber den Ausdehnungsmaßen des adaptiven Spiegels. Der adaptive Spiegel kann auch eine Manipulation der Wellenfront des Lichtes auf dem Strahlengang durch die Makrooptik ermöglichen, beispielsweise um eine axiale Veränderung der Fokussierung/Defokussierung zu erreichen. Der adaptive Spiegel kann ein justierbares Element zur Kompensation von Abbildungsfehlern sein. Ein adaptiver Spiegel kann ein Membranspiegel, ein elektrostatischer Spiegel, ein bimorpher Piezospiegel, ein piezogetriebener (z. B. poliergefräster) Metallspiegel oder dergleichen sein.

In einer vorteilhaften Ausführungsform der erfindungsgemäßen Einrichtung zur Bebilderung einer Druckform kann die Makrooptik wenigstens eine bewegbare Linse, alternativ dazu einen bewegbaren Spiegel, umfassen. Die bewegbare Linse ist insbesondere deshalb bevorzugt, da trotz Bewegung der Linse die Telezentrie der Makrooptik erhalten bleibt. Wenn die Druckform oder Druckplatte auf einem Zylinder aufgespannt wird, führt die Befestigung häufig zu einer störenden Wölbung ("plate bubble"), welche in der Größenordnung mehrerer 100 Mikrometer liegen kann. Aufgrund der Wölbung kann die Druckformoberfläche außerhalb des nutzbaren Fokusbereich der Laserstrahlung zu liegen kommen, so dass die Leistungsdichte der Laserstrahlung in einer derartigen Entfernung von der Fokusposition nicht ausreicht, um ein akzeptables Bebilderungsergebnis zu erzielen.

Mit einer bewegbaren Linse in der Makrooptik ist es auf einfache Weise möglich, die Fokusposition der Laserstrahlung in Richtung der optischen Achse zu verschieben (Umfokussierung). Die Genauigkeitsanforderungen an diese Umfokussierung resultieren aus der Tiefenschärfe der Laserstrahlen. Die erfindungsgemäße Einrichtung ermöglicht eine einfache Integration der Funktionalität einer Fokusverschiebung. Die Einrichtung weist einen definierten Abstand zwischen letzter optischer Komponente und Druckform auf, wobei sich der Abstand durch eine Fokusverschiebung nicht ändert. Gleichzeitig kann ein gutes Übersetzungsverhältnis zwischen dem Verschiebungsweg der bewegbaren Linse und der Fokuslagevariation erreicht werden.

In einer vorteilhaften Ausführungsform der Einrichtung zur Bebilderung einer Druckform sind die Lichtquellen einzeln ansteuerbare Laser. Jede Lichtquelle entspricht einem einzeln adressierbaren Bebilderungskanal mit einem Bebilderungsstrahl. Die Lichtquellen können insbesondere im infraroten (bevorzugt), sichtbaren oder ultravioletten Spektralbereich emittieren. Die Laser können in vorteilhafter Weiterentwicklung abstimmbar und/oder gepulst im Nanosekunden-, Pikosekunden- oder Femtosekundenregime betrieben werden. Insbesondere können die einzeln ansteuerbaren Laser Diodenlaser oder Festkörperlaser sein. Die einzeln ansteuerbaren Laser können auf einem oder mehreren Barren integriert sein, insbesondere kann es sich um einen oder mehrere einzeln ansteuerbaren Diodenlaserbarren (IAB), bevorzugt single-mode, handeln. Ein typisches IAB umfasst 4 bis 1000 Laser, insbesondere 30 bis 260 Laser. Die Laser liegen bevorzugt im wesentlichen gleichmäßig beabstandet auf dem IAB, insbesondere in einer Linie (eindimensionales Array) oder auf einem Gitter (zweidimensionales Array).

In der erfindungsgemäßen Einrichtung zur Bebilderung einer Druckform kann der Anzahl von Lichtquellen eine Mikrooptik entlang dem Strahlengang nachgeordnet sein, welche der Makrooptik entlang dem Strahlengang vorgeordnet ist. Für Diodenlaser, insbesondere auf einem Barren, kann die Mikrooptik unter anderem zur Anpassung der Strahldurchmesser genutzt werden: Aufgrund der sehr kleinen Durchmesser der einzelnen Laserstrahlen an der Frontseite des IAB, typischerweise wenige Mikrometer in horizontaler Richtung, slow axis, und wenige Mikrometer in vertikaler Richtung, fast axis, ist eine Anpassung der Strahldurchmesser in beiden Achsen unabhängig voneinander erforderlich, um die auf der Druckform erforderlichen Durchmesser, typischerweise wenige Mikrometer in horizontaler bzw. vertikaler Richtung, zu erreichen. Es ist angestrebt, möglichst ideale Gaußsche Laserstrahlen in der Grundmode zu erzielen, da diese die höchste natürliche Tiefenschärfe aufweisen und damit maximal unempfindlich gegenüber Fokusverschiebungen oder "plate bubble" sind. Bevorzugt werde die Laser im single mode betrieben. Den einzeln ansteuerbaren Lasern kann eine Mikrooptik nachgeordnet sein, durch welche die Strahldurchmesser der aus den Lasern austretenden Lichtstrahlen in zwei zueinander orthogonalen Achsen unabhängig voneinander beeinflussbar sind, unabhängig voneinander eingestellt werden können. Die Bildpunkte der Mikrooptik (Zwischenbild) können reell oder virtuell sein. Insbesondere kann die Mikrooptik ein virtuelles vergrößertes Zwischenbild der Anzahl von Lichtquellen erzeugen, welches durch die Makrooptik abgebildet wird.

Es ist besonders vorteilhaft, wenn in der erfindungsgemäßen Einrichtung zur Bebilderung einerDruckform die Einkoppelung des Lichtes der Anzahl von Lichtquellen in die Makrooptik über wenigstens ein Lichtumlenkelement erfolgt. Durch diese Maßnahme kann der Aufbau noch kompakter gemacht werden. Bevorzugt kann als Lichtumlenkelement, alternativ zu einem Spiegelpaar, ein Porroprisma verwendet werden, um das Licht der Anzahl von Lichtquellen in die Makrooptik einzukoppeln. Mittels eines Porroprismas kann auch eine Justierung des Strahlenganges durch die Makrooptik erfolgen.

In vorteilhafter Ausführung ist die Makrooptik der erfindungsgemäßen Einrichtung beidseitig telezentrisch. Es sei in diesem Zusammenhang betont, dass die Telezentrie beim Fokussieren, beispielsweise mittels eines adaptiven Spiegels oder einer beweglichen Linse in der Makrooptik der erfindungsgemäßen Einrichtung, erhalten bleibt. In anderen Worten ausgedrückt, mittels der oben näher beschriebenen Fokusverschiebung wird der Objekt-Bild-Abstand verändert, wobei die Gegenstandsweite fixiert ist. Mit einem über den ganzen Bereich telezentrischen Strahlengang wird erreicht, dass die Größe des Bildes in den zur Strahlausbreitung (optischen Achse) orthogonalen Richtungen nicht oder nur in sehr kleinen Toleranzen, typischerweise ±1 Mikrometer, verändert wird. Des weiteren kann in vorteilhafter Weise vorgesehen sein, dass die Makrooptik im wesentlichen eine Abbildung ohne Größenänderung, insbesondere bevorzugt eine 1:1 Abbildung ermöglicht. Die Brennweite der Makrooptik ist bevorzugt unendlich.

In einer vorteilhaften Ausführung der erfindungsgemäßen Einrichtung kann der Makrooptik eine Korrekturoptik zur Einstellung der Bildgröße entlang dem Strahlengang nachgeordnet sein. Die Korrekturoptik ermöglicht eine sehr hohe Positionsgenauigkeit der Bildpunkte und bevorzugt auch eine sehr genaue Einstellung der Bildgröße. Bevorzugt ist die Korrekturoptik ein Zoomobjektiv aus zwei Linsen. Das Zoomobjektiv selbst ist wie die Makrooptik beidseitig telezentrisch. Die Telezentrie bleibt beim Anpassen der Bildgröße erhalten.

In vorteilhafter Ausführung der erfindungsgemäßen Einrichtung können benachbarte Bildpunkte der Anzahl von Bildpunkten der Lichtquellen auf der Druckform im wesentlichen einen gleichmäßigen Abstand a aufweisen, wobei der Abstand a ein ganzzahliges Vielfaches des minimalen Druckpunktabstands p ist. Insbesondere kann in vorteilhafter Weise die Anzahl der Lichtquellen n betragen, wobei n teilerfremd zu der Zahl (a/p) ist, so dass ein redundanzfreies Interleave-Verfahren zur Bebilderung der Druckform durchgeführt werden kann. Offensichtlich sind n und (a/p) nicht beide gleichzeitig 1.

In einer bevorzugten Ausführungsform der erfindungsgemäßen Einrichtung zur Bebilderung einer Druckform kann die zu bebildemde Druckform auf einem rotierbaren Zylinder aufgenommen sein. Alternativ dazu kann die Oberfläche eines rotierbaren Zylinders eine Druckform bilden. In anderen Worten, die Druckform kann eine plattenförmige (mit einem Rand) oder hülsenförmige (mit zwei Rändern) Druckform sein. Es kann sich um eine einfach beschreibbare (konventionelle), wiederbeschichtbare oder wiederbeschreibbare Druckform handeln. Unter einer Druckform wird im Zusammenhang dieser Darstellung der erfindungsgemäßen Einrichtung auch eine sogenannte digitale Druckform verstanden. Eine digitale Druckform ist eine Oberfläche, welche als Zwischenträger für Druckfarbe dient, bevor diese auf einen Bedruckstoff übertragen wird.

Die Oberfläche kann dabei an sich in farbannehmende und farbabstoßende Bereiche strukturiert sein oder nur strukturiert mit Druckfarbe durch die Bebilderung versehen worden sein. Die digitale Druckform kann durch die Wechselwirkung mit Laserstrahlung in Bereiche strukturiert werden, die Druckfarbe an einen Bedruckstoff oder einen Zwischenträger abgeben beziehungsweise nicht abgeben. Die Strukturierung der digitalen Druckform kann vor oder nach der Beaufschlagung der Druckform mit Farbe stattfinden. Die Druckform kann auch zum Beispiel für die Verwendung in einem Thermotransferverfahren im wesentlichen aus der Druckfarbe an sich bestehen.

Die erfindungsgemäße Einrichtung zur Bebilderung kann mit besonderem Vorteil in einem Druckformbelichter oder einem Druckwerk einer Druckmaschine eingesetzt sein. Ein Druckwerk kann eine oder mehrere Einrichtungen zur Bebilderung umfassen. Mehrere Einrichtungen können derart angeordnet sein, dass sie zeitlich parallel Teilbereiche einer Druckform belichten können. Eine erfindungsgemäße Druckmaschine, welche ein oder mehrere erfindungsgemäße Druckwerke aufweist, kann eine bahnverarbeitende oder bogenverarbeitende Maschine sein. Eine bogenverarbeitende Maschine kann typischerweise einen Anleger, einen Ausleger und eine oder mehrere Weiterverarbeitungsstationen, wie beispielsweise ein Lackwerk oder einen Trockner umfassen. Einer bahnverarbeitenden Druckmaschine kann ein Falzapparat nachgeordnet sein. Das zugrundeliegende Druckverfahren des erfindungsgemäßen Druckwerks oder der erfindungsgemäßen Druckmaschine kann ein direktes oder indirektes Flachdruckverfahren, ein Flexodruckverfahren, ein Offsetdruckverfahren, ein digitales Druckverfahren oder dergleichen sein.

Im Zusammenhang des erfinderischen Gedankens steht auch ein Verfahren zur relativen Veränderung der Lage eines Bildpunktes zur Lage einer Druckform in einer Einrichtung zur Bebilderung einer Druckform, mit einer Anzahl von Lichtquellen und einer Abbildungsoptik zur Erzeugung einer Anzahl von Bildpunkten der Lichtquellen auf der Druckform, wobei die Abbildungsoptik wenigstens eine Makrooptik umfasst. Das erfindungsgemäße Verfahren zeichnet sich durch das Verschieben einer Linse der Makrooptik, durch welche der Strahlengang zweifach verläuft, aus. Bei Verwendung einer Makrooptik, durch welche der Strahlengang zweifach verläuft, kann durch das Verschieben einer Linse in der Makrooptik eine Veränderung des Objekt-Bild-Abstandes, wobei die Gegenstandsweite fixiert ist, erreicht werden. Die Telezentrie bleibt in vorteilhafter Weise erhalten. Bevorzugt kann das erfindungsgemäße Verfahren mit einer Einrichtung zur Bebilderung einer Druckform, wie sie in dieser Darstellung beschrieben ist, durchgeführt werden.

Weitere Vorteile und vorteilhafte Ausführungsformen und Weiterbildungen der Erfindung werden anhand der nachfolgenden Figuren sowie deren Beschreibungen dargestellt. Es zeigt im Einzelnen:
- Figur 1: eine Darstellung einer bevorzugten Ausführungsform der Abbildungsoptik der endungsgemäßen Einrichtung zur Bebilderung einer Druckform,
- Figur 2: eine Darstellung einer bevorzugten Ausführungsform der Mikrooptik der erfindungsgemäßen Einrichtung zur Bebilderung einer Druckform mit dem Teilbild A in der vertikalen Ebene und mit dem Teilbild B in der horizontalen Ebene,
- Figur 3: eine schematische Darstellung einer vorteilhaften Ausführungsform der erfindungemäßen Einrichtung zur Bebilderung einer Druckform auf einem Druckformzylinder, und
- Figur 4: eine schematische Darstellung einer vorteilhaften Ausführungsform der erfindungsgemäßen Einrichtung zur Bebilderung einer Druckform in einem Druckwerk einer Druckmaschine.

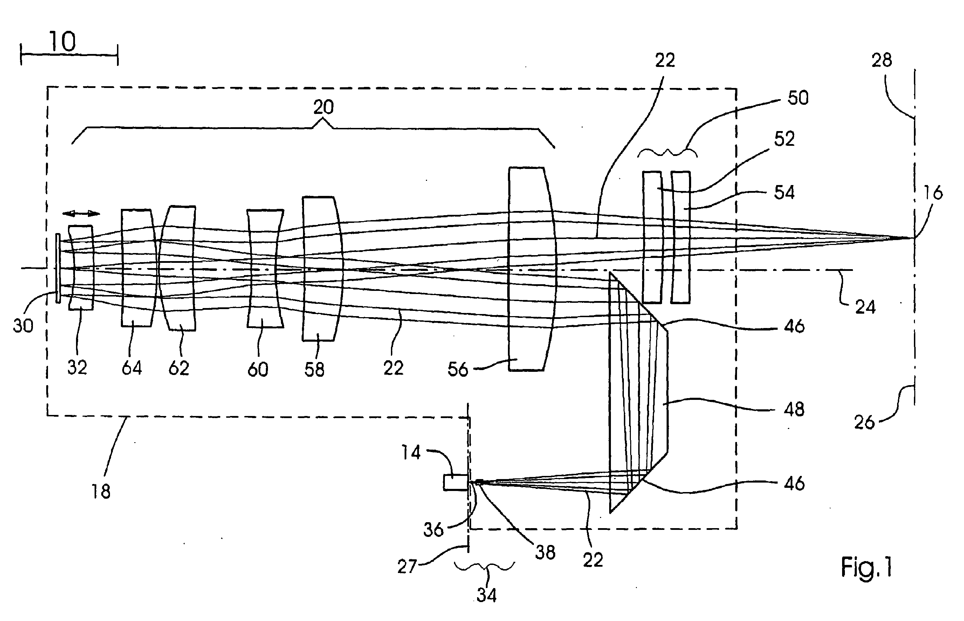

Die Figur 1 zeigt eine Darstellung einer bevorzugten Ausführungsform der Abbildungsoptik der erfindungsgemäßen Einrichtung zur Bebilderung einer Druckform. Die Abbildungsoptik 18 umfasst entlang dem Strahlengang 22, von der Anzahl von Lichtquellen 14, in bevorzugter Ausführung ein individuell ansteuerbarer Diodenlaserbarren (IAB), ausgehend eine Mikrooptik 34, ein Porroprisma 48, eine Makrooptik 20, ein Objektiv, welches eine 1:1 Abbildung bewirkt, und eine Korrekturoptik 50. Die Abbildungsoptik 18 erzeugt eine Anzahl von Bildpunkten 16 der Anzahl von Lichtquellen 14. Links oben in der Figur 1 ist ein Maßstab in Millimetern für quantitative Zwecke angebracht.

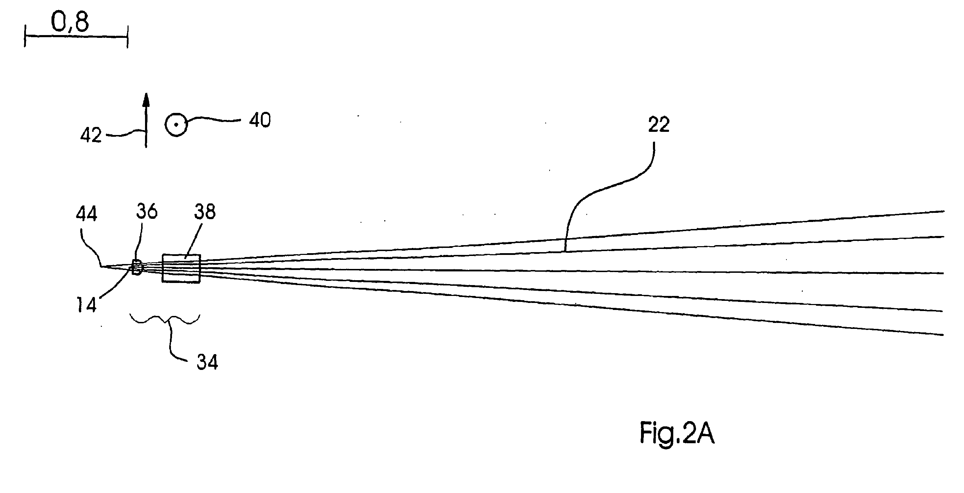

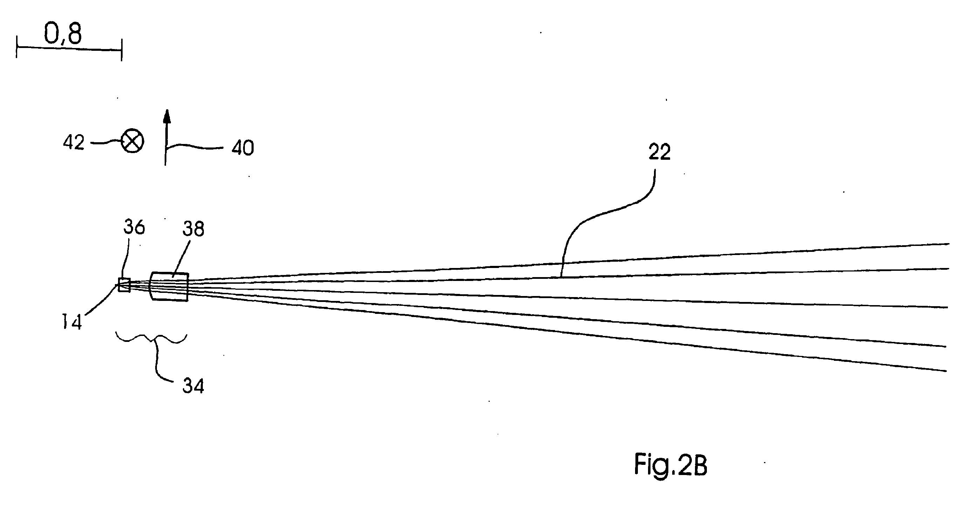

Mit Hilfe der Mikrooptik 34 lassen sich die Strahldurchmesser in den beiden zueinander orthogonalen Richtungen senkrecht zur Ausbreitungsrichtung (optischen Achse) unabhängig voneinander beeinflussen. Sie ermöglicht eine Anpassung der Größe der zu bebildernden Punkte. Die Figur 2 dient der näheren Erläuterung der Mikrooptik 34, welche eine fast axis Linse 36 und eine slow axis Linse 38 umfasst. Die Anzahl von Lichtquellen 14 und die Mikrooptik 34 können auch in einem Gehäuse gemeinsam gekapselt sein. Das Porroprisma 48, alternativ zwei Spiegel, dient zur Einkoppelung des Lichtes in das mehrlinsige 1:1 Objektiv der Makrooptik 20 sowie zur Justierung der Strahlen in der Bildebene. Innenseiten des Porroprismas 48 dienen als Lichtumlenkelemente 46 mittels Totalreflexion. Die Makrooptik 20 umfasst eine erste Linse 56, eine zweite Linse 58, eine dritte Linse 60, eine vierte Linse 62, eine fünfte Linse 64, eine bewegbare Linse 32 (Bewegungsrichtung durch Doppelpfeil angedeutet) und einen Spiegel 30. Die Linsen der Makrooptik und der Spiegel 30 sind axialsymmetrisch um die optische Achse 24 angeordnet. Der Strahlengang 22 verläuft nicht entlang der optischen Achse 24, sondern nicht-zentrisch oder off-axis. Durch den bevorzugt hochreflektierend beschichteten Spiegel 30 wird das Licht reflektiert und durchläuft die Mikrooptik 20 erneut, bezogen auf den ersten Weg allerdings symmetrisch gespiegelt an der optischen Achse 24. In anderen Worten ausgedrückt, der Strahlengang 22 verläuft gefaltet durch die Makrooptik 20. Die erste Hauptebene 26 und die zweite Hauptebene 28 der Makrooptik liegen - insbesondere symmetrisch - auf einer Seite der Makrooptik 20. In der in Figur 1 gezeigten bevorzugten Ausführungsform ist der Makrooptik 10 ein Porroprisma 48 vorgeordnet. In Konsequenz werden Punkte der gespiegelten Hauptebene 27, in welcher sich die Lichtquellen 14 befinden, auf die zweite Hauptebene 28 der Makrooptik 20 abgebildet.

Zur Anpassung der Fokuslage der Bildpunkte 16 wird der Objekt-Bild-Abstand der zweimal vom Strahlengang durchlaufenen Makrooptik 20 gezielt verändert. Dieses geschieht in dieser Ausrührungsform durch Verschiebung der bewegbaren Linse 32. Durch den zweifachen Durchgang sowie die geeignete Auslegung der Makrooptik 20 wird ein gutes Übersetzungsverhältnis zwischen der Verschiebung der bewegbaren Linse 32 und der Veränderung der Fokuslage der Bildpunkte 16 erreicht, eine Verschiebung um s bewirkt eine Veränderung um m*s, wobei m >>1. Der Strahlengang durch die Makrooptik 20 ist telezentrisch. Zur Feinkorrektur der Bildgröße ist in der in Figur 1 gezeigten Ausführungsform der Makrooptik 20 eine telezentrische Korrekturoptik 50 mit einer ersten Linse 52 und einer zweiten Linse 54 nachgeordnet. Die Korrekturoptik 50 ist ein zweilinsiges Zoomobjektiv, welches eine stufenlose Einstellung der Bildgröße im Bereich von plus und minus einigen wenigen Prozent, etwa von 0,9 bis 1,1, gestattet.

Die Figur 2 ist eine Darstellung einer bevorzugten Ausführungsform der Mikrooptik der erfindungsgemäßen Einrichtung zur Bebilderung einer Druckform. Im Teilbild A ist die Ansicht in der vertikalen Ebene mit der Vertikalrichtung 42 und der Horizontalrichtung 40 aus der Papierebene der Figur hinaus gezeigt, während im Teilbild B die Ansicht in der horizontalen Ebene mit der Horizontalrichtung 40 und der Vertikalrichtung 42 in die Papierebene hinein gezeigt ist. Links oben in den Figuren 2A und 2B sind jeweils ein Maßstab in Millimetern für quantitative Zwecke angebracht. In bevorzugter Ausführungsform besteht die Mikrooptik 34 aus einer fast-axis Linse 36 und einer slow-axis Linse 38. Die fast-axis Linse 36 ist eine einseitig polierte Glasfaser, welche die Divergenz aller Strahlen der Anzahl von Lichtquellen 14 in deren fast-axis reduziert. Die slow-axis Linse 38 ist ein Array aus einer Anzahl von Zylinderlinsen, deren Anzahl mit der Anzahl von Lichtquellen übereinstimmt, wobei jede einzelne Linse die Divergenz der Strahlen der der Linse zugeordneten Lichtquelle 14 reduziert. Die Mikrooptik 34 ist derart ausgelegt, dass ein virtuelles Zwischenbild 44 erzeugt wird.

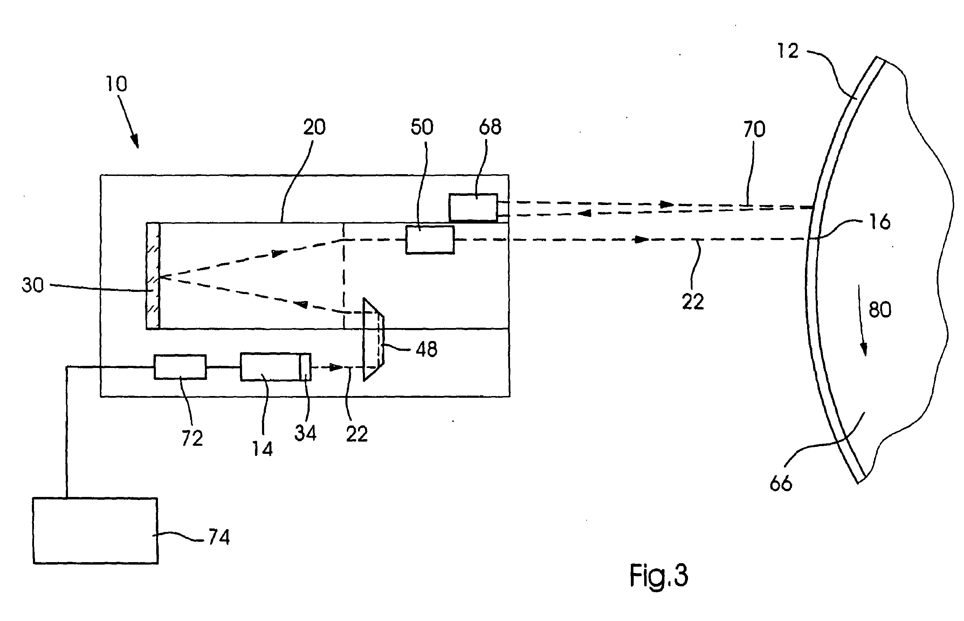

Die Figur 3 bezieht sich auf eine schematische Darstellung einer vorteilhaften Ausführungsform der erfindungsgemäßen Einrichtung zur Bebilderung einer Druckform auf einem Druckformzylinder. Die Figur 3 zeigt eine Einrichtung zur Bebilderung 10 einer Druckform 12, welche auf einem Druckformzylinder 66 aufgenommen ist. Die Strahlen einer Anzahl von Lichtquellen 14, hier einzeln ansteuerbare Diodenlaser auf einem Barren, werden mittels einer Mikrooptik 34 geformt, dann mittels eines Porroprismas 48 in eine Makrooptik 20 mit Spiegel 30 eingekoppelt. Der Strahlengang 22 durchläuft die Makrooptik 20 zweifach und passiert anschließend eine Korrekturoptik 50. Die Lichtquellen 14 werden auf Bildpunkte 16 auf der Druckform 12 abgebildet. Um die Lage der Druckform 12 im Vergleich zur Fokuslage der Abbildungsoptik der Einrichtung zur Bebilderung 10 zu bestimmen, ist ein Triangulationssensor 68 integriert. Das Sensorlicht 70 wird an der Oberfläche der Druckform 12 reflektiert, so dass eine Abstandbestimmung möglich ist. Die Oberfläche der Druckform kann deutliche Wölbungen in der Größenordnung von mehreren 100 Mikrometern aufweisen ("plate bubble"), so dass eine Veränderung der Fokuslage durch die bewegliche Linse 32 vorgenommen wird. Der Triangulationssensor 68 kann eine Messung an einer Stelle der Druckform 12 vornehmen, welche erst in einem späteren Zeitpunkt im Bildfeld der Bildpunkte 16 durch Rotation des Druckformzylinders 66 in Drehrichtung 80 erreicht wird. Es kann sich auch um eine Stelle handeln, welche entlang der Achse des Druckformzylinders 66 versetzt zum Bildpunkt 16 liegt. Die Anzahl von Lichtquellen 14 ist mit einem Lasertreiber 72 verbunden, welcher in Wirkverbindung mit einer Steuerungseinheit 74 steht.

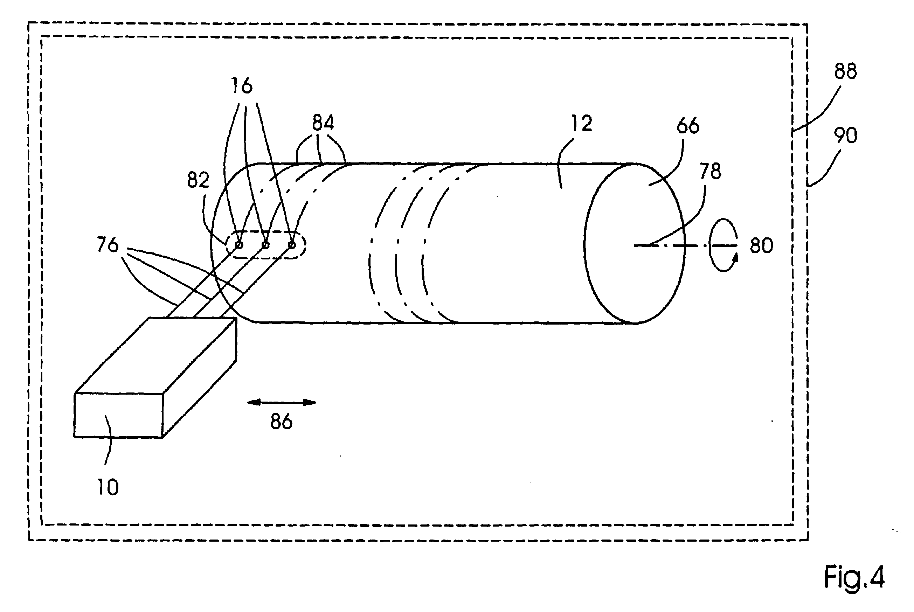

In der Figur 4 ist eine vorteilhafte Ausführungsform der erfindungsgemäßen Einrichtung zur Bebilderung einer Druckform in einem Druckwerk einer Druckmaschine schematisch dargestellt. In einem Druckwerk 88 einer Druckmaschine 90 ist eine erfindungsgemäße Einrichtung zur Bebilderung 10 einer Druckform 12 auf einem Druckformzylinder 66 zugeordnet. Beispielhaft erzeugen drei Bebilderungsstrahlen 76 drei Bildpunkte 16 in einem Bildfeld 82 auf der Druckform 12. Der Druckformzylinder 66 ist um seine Achse 78 drehbar in Drehrichtung 80, die Einrichtung zur Bebilderung 10 ist bewegbar in Translationsrichtung 86 parallel zur Achse 78. Die durch die Bildpunkte 16 verlaufende Aufspannungsgerade ist bevorzugt im wesentlichen parallel zur Achse 78 des Druckformzylinders 66 orientiert. Druckpunkte werden auf der Druckform 12 mit den Bildpunkten 16 erzeugt, welche in Zusammenwirkung der Rotation des Druckformzylinders 66 und der Translation der Einrichtung zur Bebilderung 10 entlang helixförmiger Wege 84 (Schraubenlinie) über die zweidimensionale Oberfläche der Druckform 12 geführt werden.

Bevorzugt sind der Vorschub in Translationsrichtung 86 und die Rotation in Drehrichtung 80 derart koordiniert, dass die Druckform 12 redundanzfrei, aber derart passiert wird, dass dicht liegende Druckpunkte gesetzt werden können. Um die Stellen einer zweidimensionalen Oberfläche einer Druckform 12, auf welcher Druckpunkte durch Bildpunkte 16 zu setzen sind, mit einer Anzahl von Bebilderungsstrahlen 76 (unabhängig, ob auf einer oder auf mehreren Bebilderungseinrichtungen angeordnet) redundanzfrei zu passieren, sind gewisse Vorschubregeln für die Passage von Positionen (Stellen), die in einem zeitlich vorgeordneten Schritt bebildert werden, zu Positionen (Stellen), die in einem zeitlich nachgeordneten Schritt bebildert werden, zu beachten. Diese Vorschubregeln sind insbesondere streng zu erfüllen, wenn in einem Bebilderungsschritt durch n Bebilderungsstrahlen 76 n Druckpunkte an Positionen (Stellen) gesetzt werden, die nicht dicht auf der Druckform 12 liegen, d. h. deren Abstand nicht der minimale Druckpunktabstand p (typischerweise 10 Mikrometer) ist. Betrachtet man einen Azimuthalwinkel der Druckform, so wird eine dichte Bebilderung erzielt, wenn in einem zeitlich nachgeordneten Bebilderungsschritt Druckpunkte zwischen bereits bebilderte Druckpunkte gesetzt werden. Diese Vorgehensweise ist auch unter dem Begriff Interleave-Verfahren (interleaving) bekannt. Beispielsweise ist im Dokument DE 100 31 915 A1 oder im Dokument US2002/0005890A1 ein Interleave-Verfahren zur Belichtung einer Druckform charakterisiert: Bei gegebenem minimalen Druckpunktabstand p wird für eine Reihe von n Bebilderungskanälen auf einer Aufspannungsgeraden mit gleichmäßigem Abstand zueinander, deren benachbarte Bildpunkte auf der Druckform einen Abstand a, der ein Vielfaches des minimalen Druckpunktabstandes p ist, aufweisen, ein redundanzfreier Vorschub um die Strecke (np) in Richtung der Aufspannungsgeraden gewährleistet, wenn die natürlichen Zahlen n und (a/p) teilerfremd sind. Die Beachtung einer Interleave-Vorschubregel führt zu helixförmigen Wegen 84 der Bildpunkte, welche ineinander verschränkt sind. Entlang der Ausspannungsgeraden eines Azimuthalwinkels werden Bildpunkte 16 auf einem helixförmigen Weg 84 zwischen Bildpunkte 16 von anderen helixförmigen Wegen 84 gesetzt, welche zu einem vorhergehenden Zeitpunkt bereits gesetzt worden sind. Bevorzugt wird in einem erfindungsgemäßen Druckwerk 88 mit der erfindungsgemäßen Einrichtung zur Bebilderung 10 in einem Interleave-Verfahren, insbesondere in dem im Dokument DE 100 31 915 A1 beschriebenen Interleave-Verfahren, eine Druckform 12 bebildert.

### BEZUGSZEICHENLISTE

- 10: Einrichtung zur Bebilderung
- 12: Druckform
- 14: Anzahl von Lichtquellen
- 16: Bildpunkt
- 18: Abbildungsoptik
- 20: Makrooptik
- 22: Strahlengang
- 24: optische Achse
- 26: erste Hauptebene
- 27: gespiegelte Hauptebene
- 28: zweite Hauptebene
- 30: Spiegel
- 32: bewegbare Linse
- 34: Mikrooptik
- 36: Fast Axis Linse
- 38: Slow Axis Linse
- 40: Horizontalrichtung
- 42: Vertikalrichtung
- 44: virtuelles Zwischenbild
- 46: Lichtumlenkelement
- 48: Porroprisma
- 50: Korrekturoptik
- 52: erste Linse der Korrekturoptik
- 54: zweite Linse der Korrekturoptik
- 56: erste Linse der Makrooptik
- 58: zweite Linse der Makrooptik
- 60: dritte Linse der Makrooptik
- 62: vierte Linse der Makrooptik
- 64: fünfte Linse der Makrooptik
- 66: Druckfonnzylinder
- 68: Triangulationssensor
- 70: Sensorlicht
- 72: Lasertreiber
- 74: Steuerungseinheit
- 76: Bebilderungsstrahl
- 78: Achse des Druckformzylinders
- 80: Drehrichtung
- 82: Bildfeld
- 84: Weg der Bildpunkte
- 86: Translationsrichtung
- 88: Druckwerk
- 90: Druckmaschine

## Patentansprüche

1. Einrichtung zur Bebilderung (10) einer Druckform (12), mit einer Anzahl von Lichtquellen (14) und einer Abbildungsoptik (18) zur Erzeugung einer Anzahl von Bildpunkten (16) der Lichtquellen (14) auf der Druckform (12), wobei die Abbildungsoptik (18) wenigstens eine Makrooptik (20) aus refraktiven optischen Komponenten (32, 56, 58, 60, 62, 64) umfasst und der Strahlengang (22) von den Lichtquellen (14) zu den Bildpunkten (16) zweifach durch die Makrooptik (20) verläuft,
**dadurch gekennzeichnet,**
**dass** der Strahlengang (22) symmetrisch zur optischen Achse (24) der Makrooptik (20) verläuft.

2. Einrichtung zur Bebilderung (10) einer Druckform (12) gemäß Anspruch 1,
**dadurch gekennzeichnet,**
**dass** der Strahlengang (22) nicht-zentrisch ist.

3. Einrichtung zur Bebilderung (10) einer Druckform (12) gemäß einem der vorstehenden Ansprüche,
**dadurch gekennzeichnet,**
**dass** die erste Hauptebene (26) und die zweite Hauptebene (28) der Makrooptik auf einer Seite der Makrooptik (20) liegen.

4. Einrichtung zur Bebilderung (10) einer Druckform (12) gemäß einem der vorstehenden Ansprüche,
**dadurch gekennzeichnet,**
**dass** der Makrooptik (20) wenigstens ein Spiegel (30) zugeordnet.

5. Einrichtung zur Bebilderung (10) einer Druckform (12) gemäß Anspruch 4,
**dadurch gekennzeichnet,**
**dass** die Makrooptik (20) wenigstens einen als adaptive Optik ausgeführten Teil umfasst oder dass wenigstens ein Spiegel (30) adaptiv ausgeführt ist.

6. Einrichtung zur Bebilderung (10) einer Druckform (12) gemäß einem der vorstehenden Ansprüche,
**dadurch gekennzeichnet,**
**dass** die Makrooptik (20) wenigstens eine bewegbare Linse (32) umfasst.

7. Einrichtung zur Bebilderung (10) einer Druckform (12) gemäß einem der vorstehenden Ansprüche,
**dadurch gekennzeichnet,**
**dass** die Lichtquellen (14) einzeln ansteuerbare Laser sind.

8. Einrichtung zur Bebilderung (10) einer Druckform (12) gemäß Anspruch 7,
**dadurch gekennzeichnet,**
**dass** die einzeln ansteuerbaren Laser (14) Diodenlaser oder Festkörperlaser sind.

9. Einrichtung zur Bebilderung (10) einer Druckform (12) gemäß Anspruch 7 oder 8,
**dadurch gekennzeichnet,**
**dass** die einzeln ansteuerbaren Laser (14) auf einem Barren integriert sind.

10. Einrichtung zur Bebilderung (10) einer Druckform (12) gemäß einem der vorstehenden Ansprüche,
**dadurch gekennzeichnet,**
**dass** der Anzahl von Lichtquellen (14) eine Mikrooptik (34) nachgeordnet ist, welche der Makrooptik (20) vorgeordnet ist.

11. Einrichtung zur Bebilderung (10) einer Druckform (12) gemäß Anspruch 7, 8 oder 9,
**dadurch gekennzeichnet,**
**dass** den einzeln ansteuerbaren Lasern (14) eine Mikrooptik (34) nachgeordnet ist, durch welche die Strahldurchmesser der aus den Lasern austretenden Lichtstrahlen in zwei zueinander orthogonalen Achsen unabhängig voneinander beeinflussbar sind.

12. Einrichtung zur Bebilderung (10) einer Druckform (12) gemäß Anspruch 10 oder 11,
**dadurch gekennzeichnet,**
**dass** die Mikrooptik (34) ein virtuelles Zwischenbild (44) erzeugt, welches durch die Makrooptik (20) abgebildet wird.

13. Einrichtung zur Bebilderung (10) einer Druckform (12) gemäß einem der vorstehenden Ansprüche,
**dadurch gekennzeichnet,**
**dass** die Einkoppelung des Lichtes der Anzahl von Lichtquellen (14) in die Makrooptik (20) über wenigstens ein Lichtumlenkelement (46) erfolgt.

14. Einrichtung zur Bebilderung (10) einer Druckform (12) gemäß Anspruch 8,
**dadurch gekennzeichnet,**
**dass** die Einkoppelung des Lichtes der Anzahl von Lichtquellen (14) in die Makrooptik (20) mittels eines Porroprismas (48) erfolgt.

15. Einrichtung zur Bebilderung (10) einer Druckform (12) gemäß einem der vorstehenden Ansprüche,
**dadurch gekennzeichnet,**
**dass** die Makrooptik (20) beidseitig telezentrisch ist.

16. Einrichtung zur Bebilderung (10) einer Druckform (12) gemäß einem der vorstehenden Ansprüche,
**dadurch gekennzeichnet,**
**dass** die Makrooptik (20) im wesentlichen eine 1:1 Abbildung ermöglicht.

17. Einrichtung zur Bebilderung (10) einer Druckform (12) gemäß einem der vorstehenden Ansprüche,
**dadurch gekennzeichnet,**
**dass** der Makrooptik (20) eine Korrekturoptik (50) zur Einstellung der Bildgröße nachgeordnet ist.

18. Einrichtung zur Bebilderung (10) einer Druckform (12) gemäß Anspruch 14,
**dadurch gekennzeichnet,**
**dass** die Korrekturoptik (50) ein Zoomobjektiv aus zwei Linsen (52,54) ist.

19. Einrichtung zur Bebilderung (10) einer Druckform (12) gemäß einem der vorstehenden Ansprüche,
**dadurch gekennzeichnet,**
**dass** benachbarte Bildpunkte (16) der Anzahl von Bildpunkten (16) der Lichtquellen (14) auf der Druckform (12) im wesentlichen einen gleichmäßigen Abstand a aufweisen, wobei der Abstand a ein ganzzahliges Vielfaches des minimalen Druckpunktabstands p ist.

20. Einrichtung zur Bebilderung (10) einer Druckform (12) gemäß Anspruch 19,
**dadurch gekennzeichnet,**
**dass** die Anzahl der Lichtquellen (14) n beträgt, wobei n teilerfremd zu der Zahl (a/p) ist.

21. Druckwerk (88),
**gekennzeichnet durch**
wenigstens eine Einrichtung zur Bebilderung (10) einer Druckform (12) gemäß einem der vorstehenden Ansprüche.

22. Druckmaschine (90),
**gekennzeichnet durch**
wenigstens ein Druckwerk (88) gemäß Anspruch 22.

23. Verfahren zur relativen Veränderung der Lage eines Bildpunktes (16) zur Lage einer Druckform (12) in einer Einrichtung zur Bebilderung (10) einer Druckform (12), mit einer Anzahl von Lichtquellen (14) und einer Abbildungsoptik (18) zur Erzeugung einer Anzahl von Bildpunkten (16) der Lichtquellen (14) auf der Druckform (12), wobei die Abbildungsoptik (18) wenigstens eine Makrooptik (20) umfasst,
**gekennzeichnet durch**
Verschieben einer Linse (32) in der Makrooptik (20), **durch** welche der Strahlengang (22) von den Lichtquellen (14) zu den Bildpunkten (16) zweifach verläuft.

24. Verfahren zur relativen Veränderung der Lage eines Bildpunktes (16) zur Lage einer Druckform (12) gemäß Anspruch 23,
**gekennzeichnet durch**
Einsetzen einer Einrichtung zur Bebilderung (10) einer Druckform (12) gemäß einem der Ansprüche 1 bis 21.

## Claims

1. Device for imaging (10) a printing forme (12) including a number of light sources (14) and an optical imaging system (18) for creating a number of image dots (16) of the light sources (14) on the printing forme (12), the optical imaging system (18) including at least one macrooptics (20) consisting of refractive optical components (32, 56, 58, 60, 62, 64) and the optical path (22) from the light sources (14) to the image dots (16) passing twice through the macrooptics (20),
**characterized by**
the fact that the optical path (22) is symmetrical to the optical axis (24) of the macrooptics (20).

2. Device for imaging (10) a printing forme (12) according to Claim 1,
**characterized by**
the fact that the optical path (22) is non-centric.

3. Device for imaging (10) a printing forme (12) according to one of the preceding claims,
**characterized by**
the fact that the first main plane (26) and the second main plane (28) of the macrooptics are located on one side of the macrooptics (20).

4. Device for imaging (10) a printing forme (12) according to one of the preceding claims,
**characterized by**
the fact that at least one mirror (30) is assigned to the macrooptics (20).

5. Device for imaging (10) a printing forme (12) according to Claim 4,
**characterized by**
the fact that the macrooptics (20) comprises at least one part designed as an adaptive optics or that at least one mirror (30) is designed to be adaptive.

6. Device for imaging (10) a printing forme (12) according to one of the preceding claims,
**characterized by**
the fact that the macrooptics (20) comprises at least one movable lens (32).

7. Device for imaging (10) a printing forme (12) according to one of the preceding claims,
**characterized by**
the fact that the light sources (14) are individually controllable lasers.

8. Device for imaging (10) a printing forme (12) according to Claim 7,
**characterized by**
the fact that the individually controllable lasers (14) are diode lasers or solid-state lasers.

9. Device for imaging (10) a printing forme (12) according to Claim 7 or 8,
**characterized by**
the fact that the individually controllable lasers (14) are integrated on a bar.

10. Device for imaging (10) a printing forme (12) according to one of the preceding claims,
**characterized by**
the fact that a microoptics (34) is arranged downstream of the number of light sources (14) the number of light sources (14) and upstream of the macrooptics (20).

11. Device for imaging (10) a printing forme (12) according to Claim 7, 8 or 9,
**characterized by**
the fact that a microoptics (34) is arranged downstream of the individually controllable lasers (14) which are capable of influencing the beam diameters of the light beams emitted by the lasers in two axes that are orthogonal to each other and independently of each other.

12. Device for imaging (10) a printing forme (12) according to Claim 10 or 11,
**characterized by**
the fact that the microoptics (34) generates a virtual intermediate image (44) which is reproduced by the macrooptics (20).

13. Device for imaging (10) a printing forme (12) according to one of the preceding claims,
**characterized by**
the fact that the light of the number of light sources (14) is coupled into the macrooptics (20) via at least one light deflecting element (46).

14. Device for imaging (10) a printing forme (12) according to Claim 8,
**characterized by**
the fact that the light of the number of light sources (14) is coupled into the macrooptics (20) by means of a Porro prism (48).

15. Device for imaging (10) a printing forme (12) according to one of the preceding claims,
**characterized by**
the fact that the macrooptics (20) is telecentric on both sides.

16. Device for imaging (10) a printing forme (12) according to one of the preceding claims,
**characterized by**
the fact that the macrooptics (20) essentially enables a 1:1 reproduction.

17. Device for imaging (10) a printing forme (12) according to one of the preceding claims,
**characterized by**
the fact that a correcting optics (50) for adjusting the image size is provided downstream of the macrooptics (20).

18. Device for imaging (10) a printing forme (12) according to Claim 14,
**characterized by**
the fact that the correcting optics (50) is a zoom consisting of two lenses (52, 54).

19. Device for imaging (10) a printing forme according to one of the preceding claims,
**characterized by**
the fact that adjacent image dots (16) of the number of image dots (16) of the light sources (14) are at an essentially uniform spacing a on the printing forme (12), the spacing a being an integer multiple of the minimum print dot spacing p.

20. Device for imaging (10) a printing forme (12) according to Claim 19,
**characterized by**
the fact that the number of light sources (14) is n, n being coprime to the number (a/p).

21. Printing unit (88),
**characterized by**
at least one device for imaging (10) a printing forme (12) according to one of the preceding claims.

22. Printing press (90),
**characterized by**
at least one printing unit (88) according to Claim 22.

23. Method of modifying the position of an image dot (16) relative to the position of a printing forme (12) in a device for imaging (10) a printing forme (12) including a number of light sources (14) and an imaging optics (18) for creating a number of image dots (16) of the light sources (14) on the printing forme (12), the imaging optics (18) comprising at least one macrooptics (20),
**characterized by**
displacing a lens (32) in the macrooptics (20) through which the optical path (22) from the light sources (14) to the image dots (16) passes twice.

24. Method of varying the position of an image dot (16) relative to the position of a printing forme (12) according to Claim 23,
**characterized by**
the use of a device for imaging (10) a printing forme (12) according to one of claims 1 to 21.

## Revendications

1. Dispositif pour l'exposition (10) d'un cliché (12), avec un nombre de sources lumineuses (14) et une optique de reproduction (18) pour la génération d'un nombre de points d'images (16) des sources lumineuses (14) sur le cliché d'impression (12), l'optique de reproduction (18) comprenant au moins une optique macro (20) de composant optiques réfractifs (32, 56, 58, 60, 62, 64) et le trajet de rayon (22) s'étendant depuis les sources lumineuses (14) en direction des points d'image (16) de manière double en traversant l'optique macro (20),
**caractérisé en ce que** le trajet de rayon (22) s'étend symétriquement à l'axe optique (24) de l'optique macro (20).

2. Dispositif pour l'exposition (10) d'un cliché (12) selon la revendication 1,
**caractérisé en ce que**,
le trajet de rayon n'est pas centré.

3. Dispositif pour l'exposition (10) d'un cliché (12) selon l'une des revendications précédentes, **caractérisé en ce que** le premier plan principal (26) et le second plan principal (28) de l'optique macro se trouvent sur une face de l'optique macro (20).

4. Dispositif pour l'exposition (10) d'un cliché (12) selon l'une des revendications précédentes, **caractérisé en ce que** l'optique macro (20) est associée au moins à un miroir (30).

5. Dispositif pour l'exposition (10) d'un cliché (12) selon la revendication 4,
**caractérisé en ce que** l'optique macro (20) comprend au moins une partie réalisée comme une optique adaptative ou au moins un miroir (30) est réalisé de manière adaptative.

6. Dispositif pour l'exposition (10) d'un cliché (12) selon l'une des revendications précédentes, **caractérisé en ce que** l'optique macro (20) comprend au moins une lentille mobile (32) .

7. Dispositif pour l'exposition (10) d'un cliché (12) selon la revendication 1,
**caractérisé en ce que** les sources lumineuses (14) sont individuellement des lasers commandables.

8. Dispositif pour l'exposition (10) d'un cliché (12) selon la revendication 7,
**caractérisé en ce que** les laser individuellement commandables (14) sont des diodes laser ou des laser à corps solides.

9. Dispositif pour l'exposition (10) d'un cliché (12) selon la revendication 7 ou 8,
**caractérisé en ce que** les lasers commandables individuellement (14) sont intégrés sur une barre.

10. Dispositif pour l'exposition (10) d'un cliché (12) selon l'une des revendications précédentes, **caractérisé en ce que** le nombre des sources lumineuses (14) est disposé après une micro-optique (34) qui précède une macro-optique (20).

11. Dispositif pour l'exposition (10) d'un cliché (12) selon la revendication 7, 8 ou 9
**caractérisé en ce que** les lasers individuellement commandables (14) sont disposés en aval d'une micro-optique (34) par par laquelle les diamètres de rayon des rayons lumineux sortant des lasers peuvent être influencés indépendamment les uns des autres en deux axes orthogonaux entre eux

12. Dispositif pour l'exposition (10) d'un cliché (12) selon la revendication 10 ou 11, en ce que la micro-optique (34) produit une image intermédiaire virtuelle (44) qui est reproduite par l'optique macro (20).

13. Dispositif pour l'exposition (10) d'un cliché (12) selon l'une des revendications précédentes,
**caractérisé en ce que**
l'accouplage de la lumière du nombre des sources lumineuses (14) s'effectue dans l'optique macro (20) par au moins un élément de déviation de lumière (46).

14. Dispositif pour l'exposition (10) d'un cliché (12) selon la revendication 8,
**caractérisé en ce que** l'accouplement de la lumière de sources lumineuses (14) s'effectue dans l'optique macro (20) au moyen d'un prismes porro (48).

15. Dispositif pour l'exposition (10) d'un cliché (12) selon l'une des revendications précédentes, **caractérisé en ce que** l'optique macro (20) est télécentrique bilatéralement.

16. Dispositif pour l'exposition (10) d'un cliché (12) selon l'une des revendications précédentes, **caractérisé en ce que** l'optique macro (20) permet une reproduction sensiblement 1:1.

17. Dispositif pour l'exposition (10) d'un cliché (12) selon l'une des revendications précédentes, **caractérisé en ce que** l'optique macro (20) est placée après une otique de correction (50) pour le réglage de la taille de l'image.

18. Dispositif pour l'exposition (10) d'un cliché (12) selon la revendication 14,
**caractérisé en ce que** l'optique de correction (50) est un objectif zoom composé de deux lentilles (52,54).

19. Dispositif pour l'exposition (10) d'un cliché (12) selon l'une des revendications précédentes, **caractérisé en ce que** des points d'image voisins (16) du nombre de points d'image (16) de la source lumineuse (14) sur le cliché (12) présentent sensiblement une même distance a, la distance a étant un quadruple entier de la distance minimale du point d'impression p minimal.

20. Dispositif pour l'exposition (10) d'un cliché (12) selon la revendication 19,
**caractérisé en ce que** le nombre des sources lumineuses (14) est égale à n, n étant premier avec le chiffre (a/p) ist.

21. Bloc d'impression (88) **caractérisé par** au moins un dispositif pour l'exposition (10) d'un cliché (12) selon l'une des revendications précédentes.

22. Machine d'impression (90), **caractérisé par** au moins un bloc d'impression (88) selon la revendication 22.

23. Procédé pour la modification relative de la position d'un point d'image (16) par rapport à la position d'un cliché (12) dans un dispositif d'exposition (10) d'un cliché (12), avec un nombre de sources lumineuses (14) et une optique de reproduction (18) pour la génération d'un nombre de points d'images (16) des sources lumineuses (14) sur le cliché (12), l'optique de reproduction (18) comprenant au moins une optique macro (20), **caractérisé par**
un déplacement d'une lentille (32) dans l'optique macro (20) par lequel le trajet de rayon (22) s'étend de manière double des sources lumineuses (14) aux points d'image (16).

24. Procédé pour la modification relative de la position d'un point d'image (16) par rapport à la position d'un cliché (12) **caractérisé par** l'emploi d'un dispositif d'exposition (10) d'un cliché (12) selon l'une des revendications 1 à 21.
